# EUROPÄISCHE PATENTSCHRIFT

(11) **EP 1 752 554 B1**
(45) Veröffentlichungstag und Bekanntmachung des Hinweises auf die Patenterteilung: **17.10.2007**
(21) Anmeldenummer: 05016365.8
(22) Anmeldetag: 28.07.2005
(51) Int. Cl.: C23C 14/24, C23C 14/26

(54) **Bedampfervorrichtung**
Vaporizing device
Dispositif d'évaporation

(43) Veröffentlichungstag der Anmeldung: 14.02.2007
(73) Patentinhaber: Applied Materials GmbH & Co. KG, 63755 Alzenau (DE)
(72) Erfinder: Bender, Marcus, 63456 Hanau (DE); Hoffmann, Uwe, 63755 Alzenau (DE); Klemm, Günter, 63667 Nidda (DE); Haas, Dieter, 63486 Bruchköbel (DE); Englert, Ulrich, 63869 Heigenbrücken (DE)
(74) Vertreter: Schickedanz, Willi

(56) Entgegenhaltungen:
- DE-A1- 4 133 615
- DE-A1- 10 256 038
- DE-A1- 19 846 602
- US-A- 5 157 240

## Beschreibung

Die Erfindung betrifft eine Bedampfervorrichtung nach dem Oberbegriff des Patentanspruchs 1.

Moderne Flachbildschirme weisen für die Wiedergabe von Bildern Flüssigkristallelemente (LCDs) oder Plasmaelemente auf.

Neuerdings werden auch Flachbildschirme hergestellt, welche organische Leuchtdioden (OLEDs) als Farbpixel verwenden.

Ein großer Vorteil der OLEDs gegenüber den bereits bekannten Bauelementen ist ihr hoher Wirkungsgrad von über 16 % (Helmuth Lemme: OLEDs - Senkrechtstarter aus Kunststoff, Elektronik 2/2000, S. 98, rechte Spalte, 2. Absatz, Nr. [5]: Yi He; Janicky, J.: High Efficiency Organic Polymer Light-Emitting Heterostructure Devices, Eurodisplay 99, VDE-Verlag Berlin, Offenbach). Damit liegen die OLEDs weit über dem Quantenwirkungsgrad der aus anorganischen III-V-Halbleitern bestehenden LEDs.

Ferner haben OLEDs ein geringes Gewicht, weisen einen breiten Abstrahlwinkel auf, bringen eine kräftig leuchtende Farbe mit sich und sind in einem großen Temperaturbereich von -40 °C bis 85 °C einsetzbar. Vorteilhaft ist auch, dass sie bei weniger als 5 Volt betrieben werden können und nur wenig elektrische Energie verbrauchen, wodurch sich die OLEDs insbesondere für den Einbau in batteriebetriebene Geräte anbieten.

Die Herstellung der OLEDs kann mittels der OVPD-Technologie (OVPD = Organic Vapor Phase Deposition) erfolgen, wie sie in US 5 554 220 oder in DE 101 28 091 C1 beschrieben wird. Dabei werden die organischen Materialien auf eine sich auf Glas befindliche Elektrode aufgebracht. Diese Elektrode kann beispielsweise eine ITO-Elektrode (ITO = Indium-Zinn-Oxid) sein, die zuvor auf Glas aufgedampft wurde.

Auf die so entstandene OLED-Schicht können nun weitere Materialien aufgetragen bzw. aufgedampft werden, insbesondere Metallschichten, die als Gegenelektroden dienen.

Vorrichtungen zum Verdampfen von Metallen sind als solche bereits bekannt (EP 0 477 474 B1, JP 10008241 A1, DE 976068, US 4 880 960).

Bei einer Verdampfervorrichtung zum Verdampfen von Metallen, die bei der Herstellung von OLED-Flachbildschirmen zum Einsatz kommt, wird senkrecht auf den Schmelztiegel ein Verdampfergehäuse aufgesetzt (DE 102 56 038 A1). Diese Verdampfervorrichtung besitzt, wie auch die Verdampfervorrichtung gemäß DE 101 28 091 A1 ein lineares Verteilersystem. Bei diesem linearen Verteilersystem sind mehrere Verdampferöffnungen linear angeordnet. Der durch diese Öffnungen gelangende Metalldampf trifft auf ein parallel zu den Verdampferöffnungen befindliches Substrat.

Im Bereich der Austrittsöffnungen des Dampfs ist die thermische Isolation bei der Verdampfervorrichtung gemäß DE 102 56 038 A1 unterbrochen; wodurch das Verdampferrohr an dieser Stelle kälter ist als an denjenigen Stellen, wo das Verdampferrohr mit der Isolation umgeben ist. Diese Unterbrechung der thermischen Isolation führt dazu, dass die Substrate einer starken thermischen Belastung seitens des Verdampferrohrs ausgesetzt sind, weil dieses im Bereich der Austrittsöffnungen zwar relativ abgekühlt, aber immer noch sehr heiß ist und Wärme auf das Substrat abstrahlt.

Um die im Bereich der Austrittsöffnungen abgestrahlte Wärme von dem Substrat wenigstens teilweise fernzuhalten, werden bei der bekannten Vorrichtung Rückstrahlbleche vorgesehen.

Schließlich ist auch noch eine Verdampfervorrichtung bekannt, mit der verdampftes Material über eine Maske auf eine Platte niedergeschlagen werden kann (JP 2004-214185). Diese Verdampfervorrichtung weist einen Verdampfertiegel auf, in dem Material verdampft wird. Im oberen Bereich des Tiegels befindet sich ein vorspringender Teil, der gegen die Platte gerichtet ist. In dem vorspringenden Teil ist eine Öffnung vorgesehen, und zwar in Richtung vom Innern des Tiegels zur Platte. Um den vorspringenden Teil herum ist eine Abschirmung vorgesehen, die sich auf demselben oder einem niedrigeren Niveau als die Öffnung befindet, und zwar in einem Abstand von der oberen Oberfläche des Tiegels. Mit dieser Verdampfervorrichtung ist es nicht möglich, parallel zur Erdanziehungskraft ausgerichtete flächige Substrate, beispielsweise Glasscheiben zu beschichten, weil der Verdampferstrahl bzw. die Verdampferkeule parallel zur Richtung der Erdanziehungskraft abgegeben wird.

Aufgabe der Erfindung ist es, die thermische Belastung auch solcher flächigen Substrate zu verringern, deren Oberfläche parallel zur Erdanziehungskraft ausgerichtet ist.

Diese Aufgabe wird mit einer Vorrichtung gemäß den Merkmalen des Patentanspruchs 1 gelöst.

Die Erfindung betrifft somit eine Bedampfervorrichtung zum Bedampfen eines Substrats, und zwar insbesondere eines Substrats, das wärmeempfindliche Substanzen enthält, beispielsweise OLEDs. Um Wärme von diesen Substanzen fernzuhalten, weist die Bedampfervorrichtung ein Verdampferrohr mit einer besonderen Düsenleiste auf. Diese Düsenleiste, die mehrere linear angeordnete Öffnungen aufweist, springt gegenüber dem Verdampferrohr in Richtung auf das zu beschichtende Substrat vor.

Der mit der Erfindung erzielte Vorteil besteht insbesondere darin, dass die Düsenleiste dem Verdampferrohr in der Form vorgelagert ist, dass es möglich ist, das Rohr bis zur Düsenleiste hin zu isolieren, wodurch die wärmeabstrahlende Fläche reduziert wird. Durch diese verbesserte Isolation wird das Substrat erheblich besser vor der abgestrahlten Wärme geschützt, sodass auch wärmeempfindliche Substanzen, wie z. B. OLEDs, mit Metallen beschichtet werden können.

Ausführungsbeispiele der Erfindung sind in den Zeichnungen dargestellt und werden im Folgenden näher erläutert. Es zeigen:
- Fig. 1: eine perspektivische Gesamtansicht einer Bedampfervorrichtung;
- Fig. 2: eine teilweise geschnittene Bedampfervorrichtung;
- Fig. 3: einen Längsschnitt durch die Bedampfervorrichtung gemäß Fig. 1;
- Fig. 4: einen vergrößerten Ausschnitt aus Fig. 2;
- Fig. 5: eine Düsenleiste mit nach außen hin vorgelagerten und spitz zulaufenden kegelförmigen Düsen;
- Fig. 6: einen Ausschnitt eines Teils des Verdampferrohrs mit der Düsenleiste gemäß Fig. 5.

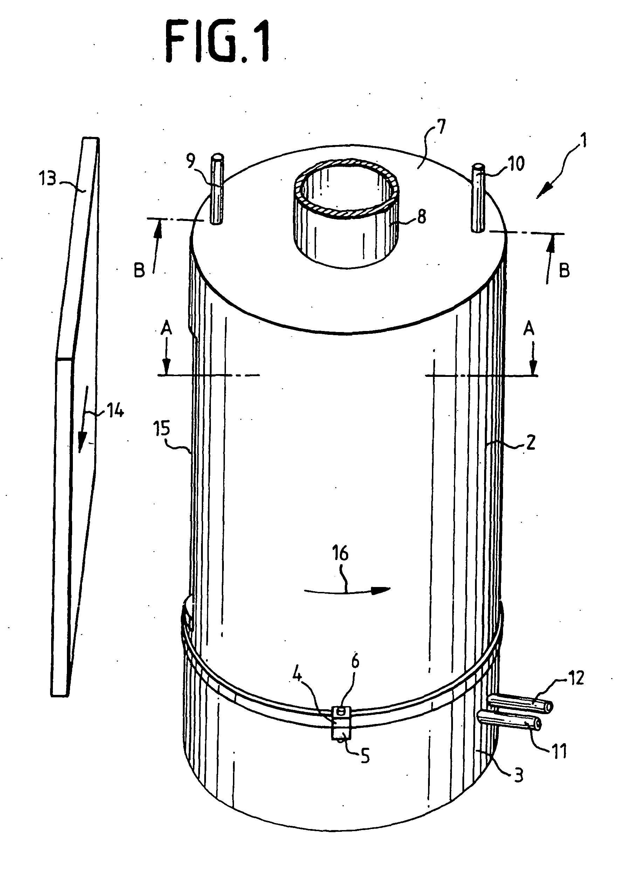

Fig. 1 zeigt eine perspektivische Gesamtansicht einer Bedampfervorrichtung 1, die einen oberen Teil 2 und einen unteren Teil 3 aufweist. Beide Teile 2, 3 werden durch eine obere und eine untere Verbindungsschelle 4, 5 sowie durch eine Schraube 6 zusammengehalten. Auf dem Umfang der Bedampfervorrichtung 1 können mehrere solche Verbindungsschellen und Schrauben vorgesehen sein.

Auf der Oberseite 7 des oberen Teils 2 ist ein Zuführungsrohr 8 angedeutet. Mit 9 und 10 sind Kühlmittelanschlüsse bezeichnet, die sich ebenfalls auf der Oberseite des oberen Teils 2 befinden.

Weitere Kühlmittelanschlüsse 11, 12 befinden sich am unteren Teil 3.

Die Bedampfervorrichtung 1 steht senkrecht, d. h. parallel zur Richtung der Erdanziehungskraft. An dieser Bedampfervorrichtung 1 wird ein zu beschichtendes Substrat 13, beispielsweise eine mit OLED beschichtete Glasplatte, vorbeigeführt, und zwar horizontal, wie es der Pfeil 14 andeutet. Das OLED kann sich dabei auf einer ITO-Schicht befinden, welche eine erste Elektrode bildet. Die nunmehr aufzudampfende Metallschicht bildet dann beispielsweise die zweite Elektrode.

Gegenüber dem Substrat 13 befindet sich ein vertikal angeordneter Spalt 15 in dem oberen Teil 2 der Bedampfervorrichtung, durch den Beschichtungsmaterial auf die Oberfläche des Substrats 13 gelangt. Das Beschichtungsmaterial gelangt somit linear und senkrecht auf die Oberfläche des Substrats 13.

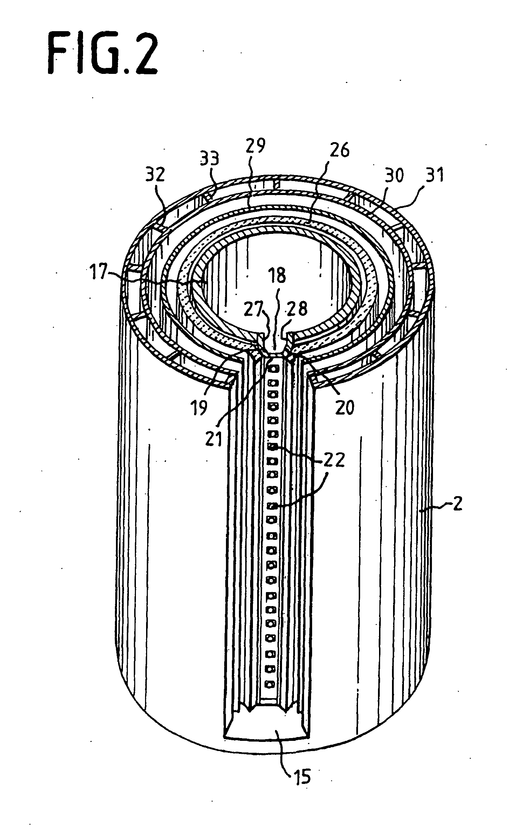

In der Fig. 2 ist der obere Teil 2 der Bedampfervorrichtung 1 noch einmal in einer teilweise geschnittenen Darstellung gezeigt. Durch den Schnitt A-A, der parallel zur Standfläche der Bedampfervorrichtung 1 erfolgt, erkennt man den Innenaufbau des oberen Teils 2.

Gegenüber der Darstellung der Fig. 1 ist der obere Teil 2 um 90 Grad gedreht, sodass man den Spalt 15 im Detail erkennt. Die Drehung erfolgt hierbei im Sinne des Pfeils 16 (Fig. 1), d. h. im Gegenuhrzeigersinn.

Bei diesem oberen Teil 2 ist ein inneres Verdampferrohr 17 an einer Stelle seines Umfangs mit einer nach außen vorspringenden Düsenleiste 18 versehen. Diese Düsenleiste 18 weist zwei Schenkel 27, 28 auf, die aus dem Umfang vorspringen und an ihren Enden über einen Steg 21 miteinander verbunden sind. In diesem Steg 21 befinden sich linear übereinander mehrere Löcher 22, die sich über die ganze Länge der Düsenleiste 18 erstrecken.

Um das Verdampferrohr 17 herum ist eine Isolierschicht 26, z. B. aus einem Grafitfilz oder speziellen Keramiken gelegt, welche bis an die Vorderkanten 19, 20 der Düsenleiste 18 herangeführt ist. Um die Isolierschicht 26 herum, die Temperaturen bis zu 1.700 °C aushalten muss, ist eine rohrförmige Abschirmung 29, z. B. aus Metall gelegt, die ihrerseits von einem doppelwandigen Rohr aus vorzugsweise Metall umgeben ist, dessen Wände 30 und 31 über Stege 32, 33 miteinander verbunden sind. Zwischen diesen Stegen 32, 33 kann ein Kühlmittel, beispielsweise Wasser fließen, d. h. die Stege 32, 33 bilden KühlmittelKanäle. Die Isolierschicht 26, die Abschirmung 29 und das doppelwandige Rohr weisen dort, wo sich die Düsenleiste 18 befindet, eine Aussparung auf.

Die Düsenleiste 18 besitzt eine sehr gute Wärmeleitfähigkeit, die wenigstens der Wärmeleitfähigkeit des Verdampferrohrs 17 entspricht.

Da die Isolierschicht 26 bis an die Vorderkanten 19, 20 der Düsenleiste 18 heranreicht, wird das restliche Verdampferrohr 17 vollständig von der Isolierschicht umfasst, sodass es keine Wärme in Richtung auf das Substrat abstrahlen kann. Die auf das Substrat abgestrahlte Wärme rührt somit nur noch von der Düsenleiste 18 her. Diese muss allerdings so heiß sein, dass keine Kondensation von Dampf erfolgt.

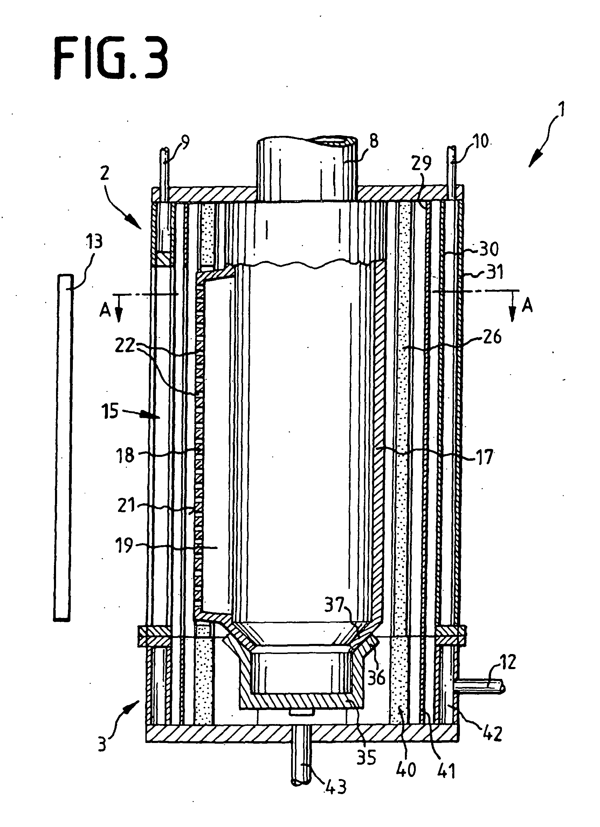

Die Fig. 3 zeigt einen Längsschnitt B-B durch die Verdampfungsvorrichtung 1 gemäß Fig. 1. Man erkennt hierbei das Verdampferrohr 17, das auf einem Tiegel 35 aufsitzt. Der Tiegel 35 weist an seinem oberen Ende eine Verbreiterung 36 auf, während das Verdampferrohr 17 an seinem unteren Ende eine Verjüngung 37 besitzt. Diese Verjüngung 37 ruht auf der Verbreiterung 36.

Den Schenkel 27 und den Steg 21 mit den Löchern 22 der Düsenleiste 18 erkennt man links von der Mitte des Verdampferrohrs 17.

Mit 40 ist eine Heizung für den Tiegel 35 bezeichnet, die den Tiegel 35 umgibt. Diese Heizung 40 ist von einer Abschirmung 41 umgeben, die ihrerseits von einer Kühlung 42 umgeben ist. Eine Zuleitung für elektrische Energie ist schematisch mit 43 bezeichnet.

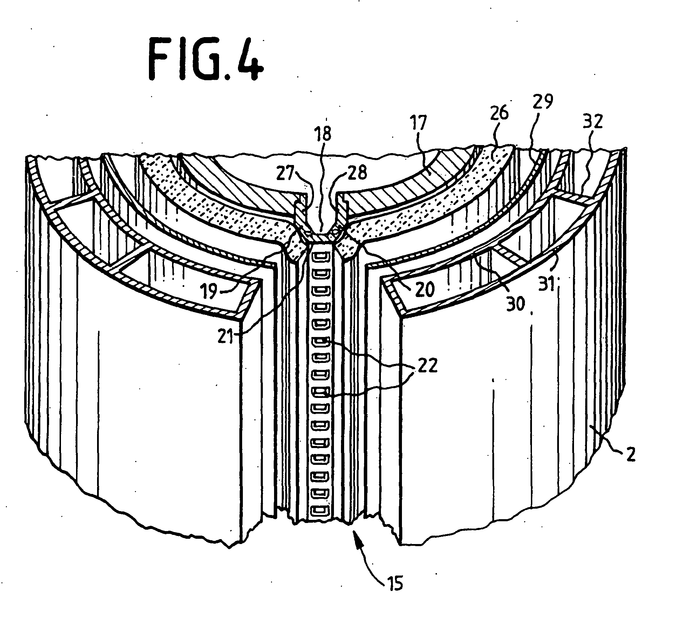

Fig. 4 zeigt eine vergrößerte Ausschnitts-Darstellung von Fig. 3. Man erkennt hierbei deutlich, dass die Isolierschicht 26 bis an die Vorderkanten 19, 20 der Düsenleiste 18 herangeführt ist. Außerdem ist erkennbar, dass die Düsenleiste 18 aus einem anderen Material als das Verdampferrohr 17 bestehen kann. Mit seinen Schenkeln 27, 28 ist es an die offenen Enden des Verdampferrohrs 17 angepasst.

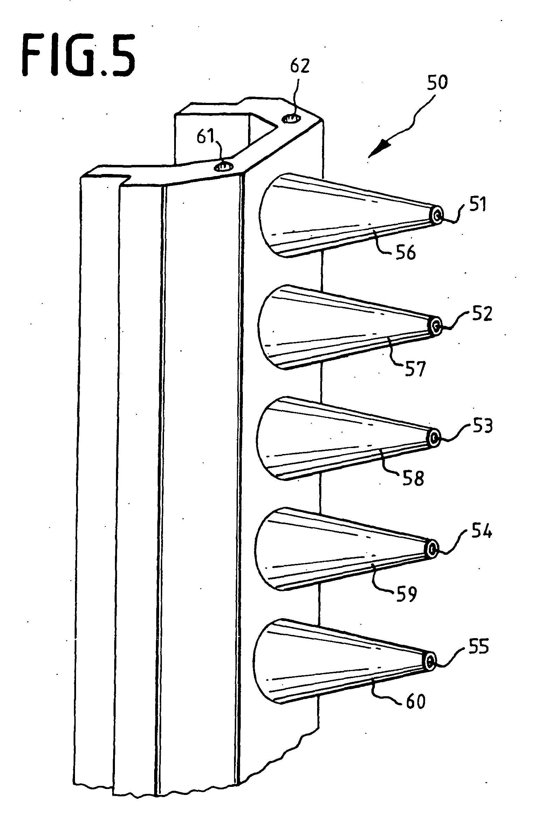

Fig. 5 zeigt einen Ausschnitt einer anderen Düsenleiste 50 mit gegenüber der Düsenleiste 18 vorgelagerten Öffnungen 51 bis 55. Diese Öffnungen 51 bis 55 bilden das Ende von nach außen schmaler werdenden Kegeln 56 bis 60, die auf der Düsenleiste 18 angeordnet sind. Mit 61, 62 sind die Bohrungen für die Heizdrähte bezeichnet. Mit solchen Heizdrähten kann die Düsenleiste 18 unabhängig vom Verdampferrohr 17 aufgeheizt werden.

Wird eine solche Düsenleiste 50 mit vorgelagerten Düsen in ein Verdampferrohr eingebaut, so ist es möglich, Isoliermaterial über die Kegel 56 bis 60 zu legen.

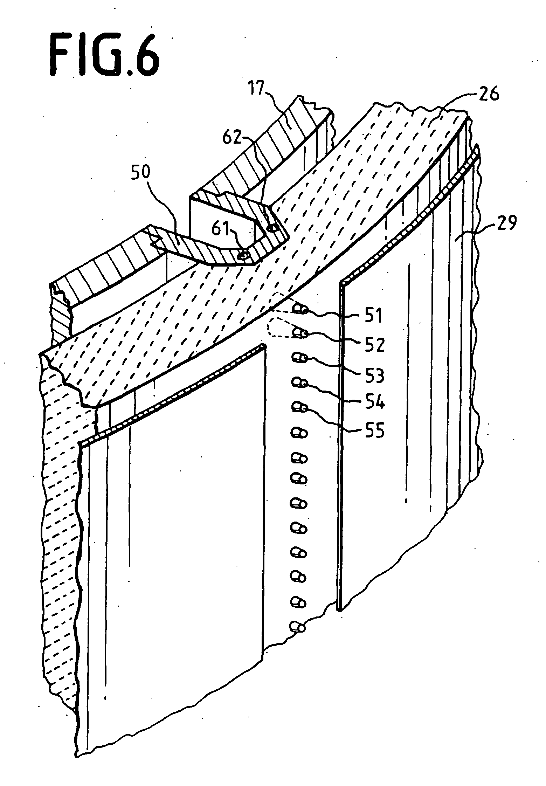

Fig. 6 zeigt, wie die Kegel 56 bis 60 der Düsenleiste 50 in das Isoliermaterial eingebettet sind. Es wird somit praktisch die ganze Düsenleiste 50 von Isoliermaterial 26 eingebettet. Lediglich die Enden der Kegel 56 bis 60 können noch Wärme abstrahlen.

Das in der Fig. 1 bis 6 dargestellte Verdampferrohr ist stets als zylindrisches Rohr gezeigt. Es versteht sich jedoch, dass es auch einen n-eckigen Querschnitt haben kann, wobei die Seiten gleich oder ungleich sind. Beispielsweise kann es einen rechteckigen, insbesondere quadratischen Querschnitt aufweisen.

In allen Fällen ermöglichst es eine kompakte Verdampferquelle, deren Länge nicht - wie bei der JP 2004-214185 - der Länge der Verdampferleiste entsprechen muss.

Die Patentansprüche 2, 3, 5 bis 12 sind auch auf den unabhängigen Patentanspruch 13 rückbezogen.

## Patentansprüche

1. Bedampfervorrichtung zum Bedampfen eines Substrats mit einer Verdampferquelle (35), in der die Oberfläche von zu verdampfendem Material im Wesentlichen senkrecht zur Richtung der Erdanziehungskraft verläuft, und mit einer Verdampferkammer (17), die sich oberhalb der Verdampferquelle (35) befindet und deren Längsachse parallel zur Richtung der Erdanziehungskraft verläuft, wobei die Verdampferkammer (17) eine mit mehreren linear angeordneten Ausgangsöffnungen versehene Düsenleiste (18) aufweist und die Ausgangsöffnungen in der Düsenleiste (18) senkrecht zur Richtung der Erdanziehungskraft verlaufen, **dadurch gekennzeichnet, dass** derjenige Bereich der Düsenleiste, in dem sich die Ausgangsöffnungen (22) befinden, der Verdampferkammer (17) vorgelagert ist.

2. Bedampfervorrichtung nach Anspruch 1, **dadurch gekennzeichnet, dass** die Verdampferkammer (17) als zylindrisches Rohr ausgebildet ist.

3. Bedampfervorrichtung nach Anspruch 1, **dadurch gekennzeichnet, dass** die Verdampferkammer als rechteckiges Rohr ausgebildet ist.

4. Bedampfervorrichtung nach Anspruch 1, **dadurch gekennzeichnet, dass** die Verdampferkammer (17) mit einer Wärmedämmschicht (26) umgeben ist, die bis an die vorgelagerte Düsenleiste (18) herangeführt ist.

5. Bedampfervorrichtung nach Anspruch 1, **dadurch gekennzeichnet, dass** die Düsenleiste (18) U-förmig ausgebildet ist, wobei die einen Enden der Seitenschenkel (27, 28) der Düsenleiste (18) mit dem Verdampferrohr (17) und die anderen Enden mit einem Steg (21) in Verbindung stehen.

6. Bedampfervorrichtung nach Anspruch 1, **dadurch gekennzeichnet, dass** die Düsenleiste (18) mit einer eigenen Heizung (61, 62) versehen ist.

7. Bedampfervorrichtung nach Anspruch 6, **dadurch gekennzeichnet, dass** die Heizung eine Widerstandsheizung ist.

8. Bedampfervorrichtung nach Anspruch 4, **dadurch gekennzeichnet, dass** die Wärmedämmschicht (26) von einer Abschirmung (29) umgeben ist.

9. Bedampfervorrichtung nach Anspruch 8, **dadurch gekennzeichnet, dass** die Abschirmung (29) von einer doppelwandigen Umhüllung (30, 31) umgeben ist, die Kühlmittel-Kanäle aufweist.

10. Bedampfervorrichtung nach Anspruch 1, **dadurch gekennzeichnet, dass** die vorgelagerte Düsenleiste (18) eine Wärmeleitfähigkeit aufweist, die mindestens so groß ist wie die des Verdampferrohrs (17).

11. Bedampfervorrichtung nach Anspruch 1, **dadurch gekennzeichnet, dass** die Düsenleiste (50) mehrere nach außen schmaler werdende Kegel (56 bis 60) aufweist, die linear angeordnet sind und an ihren Enden eine Öffnung (51 bis 55) aufweisen.

12. Bedampfervorrichtung nach Anspruch 11, **dadurch gekennzeichnet, dass** die Kegel (56 bis 60) in Isoliermaterial (26) eingebettet sind.

13. Bedampfervorrichtung zum Bedampfen eines Substrats mit einer Verdampferquelle (35) und einer wenigstens in der Nähe der Verdampferquelle (35) befindlichen Verdampferkammer (17), wobei diese Verdampferkammer (17) eine Düsenleiste (18) mit mehreren Ausgangsöffnungen (22) aufweist, **dadurch gekennzeichnet, dass** derjenige Bereich der Düsenleiste (18), in dem sich die Ausgangsöffnungen (22) befinden, der Verdampferkammer (17) vorgelagert ist und dass die Verdampferkammer (17) über ihren Umfang mit einer Wärmedämmschicht (26) versehen ist, die bis zur Düsenleiste (18) reicht, ohne die Ausgangsöffnungen (22) zu überdecken.

## Claims

1. Vapor deposition device for the vapor deposition of a substrate with an evaporator source (35), in which the surface of material to be vaporized extends substantially perpendicularly to the direction of the gravitational force of the earth, and with an evaporator chamber (17), located above the evaporator source (35) and whose longitudinal axis extends parallel to the direction of the gravitational force of the earth, wherein the evaporator chamber (17) includes a nozzle bar (18) provided with several linearly disposed outlet openings and the outlet openings in the nozzle bar (18) extend perpendicularly to the direction of the gravitational force of the earth, **characterized in that** the region of the nozzle bar, in which are located the outlet openings (22), is located forwardly of the vaporizer chamber (17).

2. Vapor deposition device as claimed in claim 1, **characterized in that** the evaporator chamber (17) is formed as a cylindrical tube.

3. Vapor deposition device as claimed in claim 1, **characterized in that** the evaporator chamber is formed as a rectangular tube.

4. Vapor deposition device as claimed in claim 1, **characterized in that** the evaporator chamber (17) is encompassed by a thermal insulating layer (26) which extends up to the nozzle bar (18), located forwardly.

5. Vapor deposition device as claimed in claim 1, **characterized in that** the nozzle bar (18) is formed in the shape of a U, wherein the one ends of the side flanks (27, 28) of the nozzle bar (18) are connected with the evaporator tube (17) and the other ends with a web (21).

6. Vapor deposition device as claimed in claim 1, **characterized in that** the nozzle bar (18) is provided with its own heating system (61, 62).

7. Vapor deposition device as claimed in claim 6, **characterized in that** the heating system is a resistance heating system.

8. Vapor deposition device as claimed in claim 4, **characterized in that** the thermal insulating layer (26) is encompassed by a shielding (29).

9. Vapor deposition device as claimed in claim 8, **characterized in that** the shielding (29) is encompassed by a double-walled jacket (30, 31) which includes cooling means channels.

10. Vapor deposition device as claimed in claim 1, **characterized in that** the nozzle bar (18) forwardly located has a thermal conductivity at least equal to that of the evaporator tube (17).

11. Vapor deposition device as claimed in claim 1, **characterized in that** the nozzle bar (50) comprises several outwardly tapering cones (56 to 60), which are arranged linearly and at their ends have an opening (51 to 55).

12. Vapor deposition device as claimed in claim 11, **characterized in that** the cones (56 to 60) are embedded in insulating material (26).

13. Vapor deposition device for the vapor deposition of a substrate with an evaporator source (35) and an evaporator chamber (17) disposed at least in the proximity of the evaporator chamber (17), wherein this evaporator chamber (17) comprises a nozzle bar (18) with several outlet openings (22), **characterized in that** that region of the nozzle bar (18), in which the outlet openings (22) are located, is located forwardly of the evaporator chamber (17) and that the evaporator chamber (17) over its circumference is provided with a thermal insulating layer (26), which extends up to the nozzle bar (18) without covering the outlet openings (22).

## Revendications

1. Dispositif de vaporisation pour la vaporisation d'un substrat, avec une source de vaporisation (35) dans laquelle la surface du matériau à vaporiser est positionnée essentiellement de façon verticale par rapport à la force d'attraction terrestre, et avec une chambre de vaporisation (17), qui est située au-dessus de la source de vaporisation (35) et dont l'axe longitudinal se prolonge de façon parallèle par rapport à la force d'attraction terrestre, la chambre de vaporisation (17) comportant une barre à buse (18) pourvue de plusieurs orifices de sortie disposés de manière linéaire, et les orifices de sortie dans la barre à buse (18) se prolongeant de manière verticale par rapport à l'attraction terrestre, **caractérisé en ce que** la région de la barre à buse dans laquelle se trouvent les orifices de sortie (22) est disposée avant la chambre de vaporisation (17).

2. Dispositif de vaporisation selon la revendication 1, **caractérisé en ce que** la chambre de vaporisation (17) est conçue comme un conduit cylindrique.

3. Dispositif de vaporisation selon la revendication 1, **caractérisé en ce que** la chambre de vaporisation est conçue comme un conduit rectangulaire.

4. Dispositif de vaporisation selon la revendication 1, **caractérisé en ce que** la chambre de vaporisation (17) est entourée d'une couche d'isolation thermique (26), qui est amenée jusqu'à la barre à buse (18) placée en amont.

5. Dispositif de vaporisation selon la revendication 1, **caractérisé en ce que** la barre à buse (18) est conçue en forme de U, les extrémités des branches latérales (27, 28) de la barre à buse (18) étant reliées d'un côté au conduit d'évaporation (17) et de l'autre côté à une tige (21).

6. Dispositif de vaporisation selon la revendication 1, **caractérisé en ce que** la barre à buse (18) est équipée d'un chauffage individuel (61, 62).

7. Dispositif de vaporisation selon la revendication 6, **caractérisé en ce que** le moyen de chauffage est un chauffage à résistance.

8. Dispositif de vaporisation selon la revendication 4, **caractérisé en ce que** la couche d'isolation thermique (26) est entourée d'une protection (29).

9. Dispositif de vaporisation selon la revendication 8, **caractérisé en ce que** la protection (29) est entourée d'une enveloppe à double paroi (30, 31), qui comporte des canaux à liquide de refroidissement.

10. Dispositif de vaporisation selon la revendication 1, **caractérisé en ce que** la barre à buse (18) installée en amont présente une conductibilité thermique, qui est au moins aussi élevée que celle du conduit de vaporisation (17).

11. Dispositif de vaporisation selon la revendication 1, **caractérisé en ce que** la barre à buse (50) comporte plusieurs cônes (56 à 60), qui s'amincissent vers l'extérieur et qui sont disposés de façon linéaire et comportent une ouverture (51 à 55) sur chacune de leurs extrémités.

12. Dispositif de vaporisation selon la revendication 11, **caractérisé en ce que** les cônes (56 à 60) sont noyés dans un matériau isolant (26).

13. Dispositif de vaporisation pour la vaporisation d'un substrat, avec une source de vaporisation (35) et une chambre de vaporisation (17) située au moins à proximité de la source de vaporisation (35), cette chambre de vaporisation (17) comportant une barre à buse (18) avec plusieurs orifices de sortie (22), **caractérisé en ce que** la région de la barre à buse (18) dans laquelle se trouvent les orifices de sortie (22) se trouve en amont de la chambre de vaporisation (17), et **en ce que** la chambre de vaporisation (17) est entourée d'une couche d'isolation thermique (26) qui se prolonge jusqu'à la barre à buse (18) sans couvrir les orifices de sortie (22).
